(19)

Europäisches
Patentamt
European
Patent Office
Office européen
des brevets

(11) **EP 2 363 721 B1**

(12) **EUROPEAN PATENT SPECIFICATION**

(45) Date of publication and mention
of the grant of the patent:
**18.01.2012 Bulletin 2012/03**

(51) Int Cl.:
***G01R 33/032*** *(2006.01)*

(21) Application number: **11000047.8**

(22) Date of filing: **05.01.2011**

(54) **Optical fiber type magnetic field sensor and sensing method**

Glasfasermagnetfeldsensor und Messverfahren

Capteur de champ magnétique de type à fibres optiques et procédé de détection

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.01.2010 JP 2010001526**

(43) Date of publication of application:
**07.09.2011 Bulletin 2011/36**

(73) Proprietor: **Mitutoyo Corporation
Kawasaki
Kanagawa 213-8533 (JP)**

(72) Inventor: **Miki, Yutaka
Kawasaki, Kanagawa 213-8533 (JP)**

(74) Representative: **Müller-Boré & Partner
Patentanwälte
Grafinger Straße 2
81671 München (DE)**

(56) References cited:
**US-A1- 2002 000 804     US-A1- 2003 133 657**

**Description**

BACKGROUND OF THE INVENTION

1. Field of the Invention

The present invention relates to an optical fiber type magnetic field sensor having a light source; an optical fiber guiding light from the light source; a polarizer linearly polarizing the light outgoing from the optical fiber; a first Faraday rotator rotating polarization of the linearly polarized light by an intensity of an external magnetic field; an optical receiver, based on the polarization-rotated light, performing a photoelectric conversion to output the light as an electrical signal; and a processor processing the electrical signal to output the intensity of the external magnetic field as an output voltage value. Furthermore, the invention relates to a magnetic field sensing or detecting method. In particular, the present invention relates to an optical fiber type magnetic field sensor capable of determining a direction of a magnetic field.

2. Description of Related Art

When passing a linearly polarized light through a crystal having the Faraday effect (such a crystal is called a Faraday rotator) such as a YIG (yttrium-iron-garnet) crystal and the like, and applying a magnetic field along a propagation direction of the light, rotation of polarization direction (called polarization rotation) of the light occurs in proportion to an intensity of the external magnetic field.

With respect to the Faraday effect, equation (1) holds:

$$\Phi \propto V \times H \times L \qquad (1)$$

Here the symbol $\Phi$ is a Faraday rotation angle (a polarization rotation angle of light). The symbol V is a Verdet constant, which varies according to the material of a Faraday rotator. The symbol H represents an intensity of an external magnetic field along a propagation direction of light (magnetic field detection axis direction O). The symbol L is a length of the magnetic field detection axis direction O of the Faraday rotator.

Here, the polarization rotation of the (linearly polarized) light occurs when there exists a component of an external magnetic field along the propagation direction of the light (the magnetic field detection axis direction O). In detail, in the Faraday effect, when the direction of an external magnetic field is the same as the propagation direction of light, the polarization of the light rotates in a rotating direction of a right-handed screw with respect to the propagation direction of the light. When the direction of the magnetic field is opposite to the propagation direction of the light, the polarization of the light rotates in a rotating direction of a left-handed screw with respect to the propagation direction of the light.

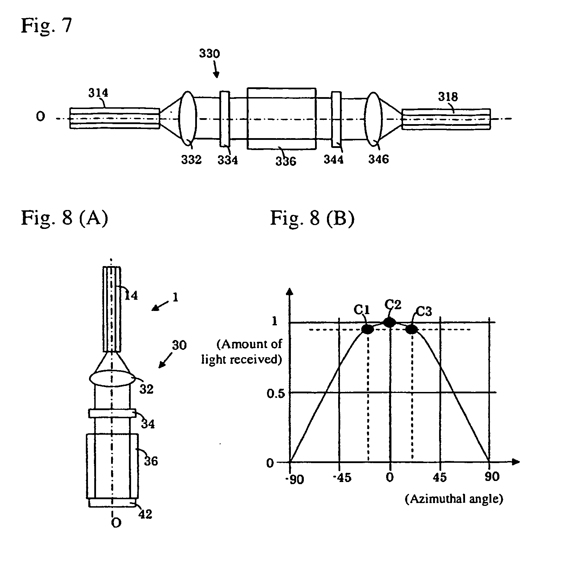

In Japanese Patent No. HEI 3-22595 B2, an optical fiber type magnetic field sensor using the above-described Faraday rotator is proposed. Using Fig. 8 (A), a magnetic field probe 30 of this optical fiber type magnetic field sensor 1 is explained.

In the magnetic field probe 30, light from a light source (not shown in the figure) is guided by an incident side optical fiber 14. The guided light is collimated by a lens 32, passes through a polarizer 34 and a (first) Faraday rotator 36, and is vertically reflected by a mirror 42. In the (first) Faraday rotator 36, a rotation angle of a polarization direction (called a polarization rotation angle) of the (linearly polarized) light becomes large according to an intensity of an external magnetic field. From this fact, with respect to a transmission axis (called a polarization axis) of the polarizer 34, a polarization rotation angle (called an azimuthal angle) of the light being reflected by the mirror 42 and returning to the incident side optical fiber 14 becomes large. Therefore, an amount of light returning to the incident side optical fiber 14 (called optical fiber feedback light amount or amount of light received) varies according to a size of the azimuthal angle. That is, by performing a photoelectric conversion to the optical fiber feedback light amount, the intensity of the external magnetic field can be determined.

The magnetic field probe 30 of the optical fiber type magnetic field sensor 1 is of a reflection type. However, in Japanese Patent No. HEI 3-22595 B2, a transmission type magnetic field probe 80, illustrated in Fig. 9 (A), is also proposed. In the magnetic field probe 80, in place of the mirror 42, an analyzer 94 passing through light passed through a (first) Faraday rotator 86 and a lens 96 collecting the light passed through the analyzer 94 are included. The light collected by the lens 96 is guided to an optical receiver (not shown in the figure) by an outgoing side optical fiber 68. The analyzer 94 has a polarization axis parallel or perpendicular to a polarization axis of a polarizer 84.

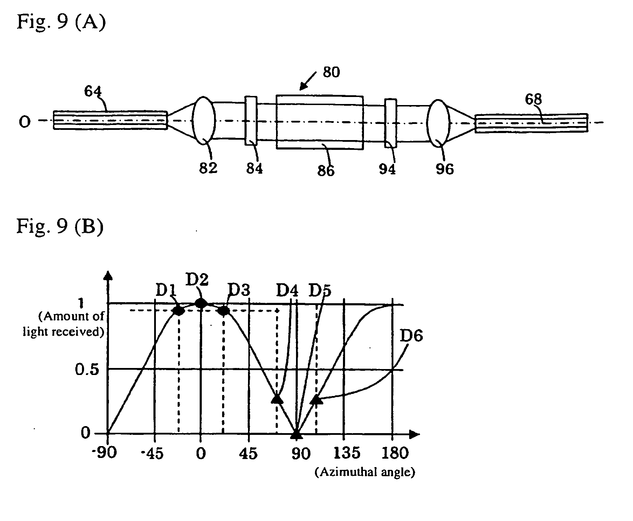

Optical fiber feedback light amounts in Japanese Patent No. HEI 3-22595 B2 are respectively illustrated in Fig. 8 (B) for the reflection type magnetic field probe 30 and in Fig. 9 (B) for the transmission type magnetic field probe 80 The reflection type magnetic field probe 30 is first explained.

The optical fiber feedback light amount (amount of light received) can be obtained with a value obtained when the azimuthal angle is 0 degree (state C2) as a maximum value (normalized to 1). However, when the intensity of the external magnetic field is the same but the direction is different, that is, in a state C1 and in a state C3, the amount of light received is the same, and the azimuthal angle cannot be determined from the amount of light received.

Similarly, in the transmission type magnetic field probe 80, when the polarization axis of the polarizer 84 is parallel to the polarization axis of the analyzer 94, as illustrated by black circle marks, the amount of light received can be obtained with a value obtained when the azimuthal angle is 0 degree (state D2) as a maximum value (normalized to 1). Therefore, when the intensity of the external magnetic field is the same but the direction is different, that is, in a state D 1 and a state D3, the amount of light received is the same, and the azimuthal angle cannot be determined from the amount of light received. When the polarization axis of the polarizer 84 is perpendicular to the polarization axis of the analyzer 94, as illustrated by black triangle marks, the amount of light received can be obtained with a value obtained when the azimuthal angle is 90 degree (state D5) as a minimum value of 0. Therefore, when the intensity of the external magnetic field is the same but the direction is different, that is, in a state D4 and a state D6, the amount of light received is the same, and the azimuthal angle cannot be determined from the amount of light received.

That is, the magnetic field probes 30 and 80 disclosed in Japanese Patent No. HEI 3-22595 B2 can determine an intensity of a magnetic field, but can not determine a direction of a magnetic field. Therefore, they cannot be used for a magnetic field distribution measurement and the like that require a direction of a magnetic field.

US 2002/0000804 A1 discloses a magnetic sensor, wherein light with a plane of polarization rotated during transmission is converted to parallel light by a collimating lens. The parallel light is transmitted through a first birefringent plate to be separated into two polarized rays orthogonal to each other regardless of the rotation of the plane of polarization. The two polarized rays have planes of polarization rotated by the strength of a magnetic field in the course of transmission through a Faraday element. The polarized rays are reflected by a mirror at a downstream stage, each ray returning along the same optical path and transmitted through the birefringent plate again. At this time, the polarized rays are separated into four polarized rays with different ratios of light intensity according to the rotation of the planes of polarization. From these rays, the collimating lens selects only two orthogonal polarized rays to be detected.; The selected rays are detected by a photodetector at a downstream stage. An arithmetic operation is carried out based on the two light intensities, thereby measuring the magnetic field with high sensitivity.

US 2003/0133657 A1 discloses a new fiber-optic magnetic field or current sensor designed to increase the accuracy, resolution and environmental stability of the subject sensor, wherein the design is based on phase-shifted fiber or planar waveguide Bragg grating, in which a Fabry-Perot resonator is formed around the phase shift. When the wavelength of incident light coincides with the wavelength of FP resonator mode, the magnetic field induced polarization rotation of the waveguided light is strongly enhanced.

## SUMMARY OF THE INVENTION

The present invention is provided to solve the above-described problem. An advantage of the present invention is to provide an optical fiber type magnetic field sensor and magnetic field sensing method capable of determining a direction of a magnetic field without the need of a complex configuration.
This object is solved according to the invention by the features of the independent claim. Preferred embodiments of the invention are subject of the dependent claims.

One aspect of the present invention is an optical fiber type magnetic field sensor having a light source; an optical fiber at least partly guiding light from the light source; a polarizer linearly polarizing the light outgoing from the optical fiber; a first Faraday rotator rotating polarization of the linearly polarized light by an intensity of an external magnetic field; an optical receiver, based on the polarization-rotated light, performing a photoelectric conversion to output the light as an electrical signal; a processor processing the electrical signal to output the intensity of the external magnetic field as an output voltage value; a polarization rotator further providing a certain non-90n degree (where n is an integer) polarization rotation angle, to a polarization rotation angle of the light outgoing from the first Faraday rotator, with respect to a polarization axis of the polarizer; and an attenuator attenuating an amount of light guided to the optical receiver by providing the certain polarization rotation angle.

According to another aspect of the present invention, the certain polarization rotation angle is 45 degrees + 90m degrees (where m is an integer).

According to another aspect of the present invention, the polarization rotator has a permanent magnet applying a bias magnetic field to the first Faraday rotator.

According to the present invention, the polarization rotator has a second Faraday rotator and a permanent magnet, the second Faraday rotator being different from the first Faraday rotator, and the permanent magnet applying a bias magnetic field to the second Faraday rotator.

According to the present invention, a magnetic shield is provided at an external periphery of the permanent magnet for reducing an effect of the permanent magnet on the first Faraday rotator.

According to another aspect of the present invention, the optical fiber type magnetic field sensor is of a reflection type, in which the attenuator has a mirror reflecting light polarization-rotated by one of the first Faraday rotator and particularly the second Faraday rotator, and the light reflected by the mirror is made incident to the polarizer.

According to another aspect of the present invention, the optical fiber type magnetic field sensor is of a transmission type, in which the attenuator has an analyzer configured to have a polarization axis angle different from that of the polarizer.

According to another aspect of the present invention, light of a plurality of wavelengths from the light source is guided to the optical fiber, light outgoing from the optical fiber is dispersed into each of the wavelengths, and the first Faraday rotator is respectively used with respect to each of the wavelengths.

According to another aspect of the present invention, the light outgoing from the optical fiber is dispersed into each of the wavelengths by using one or more dichroic mirrors.

According to another aspect of the present invention, the processor has a squarer for squaring the electrical signal.

Another aspect of the present invention is method of sensing or detecting a magnetic field, comprising the following steps: generating linearly polarized light; guiding the light to a first Faraday rotator configured to rotate polarization of the linearly polarized light by an intensity of an external magnetic field; performing a photoelectric conversion by means of an optical receiver to output the light as an electrical signal, based on the polarization-rotated light; processing the electrical signal to output the intensity of the external magnetic field as an output voltage value; providing a predetermined non-90n degree polarization rotation angle, where n is an integer, to a polarization rotation angle of light outgoing from the first Faraday rotator, with respect to a polarization axis of the polarized light; and attenuating an amount of light guided to the optical receiver by providing the predetermined polarization rotation angle.

According to another aspect of the present invention, the predetermined polarization rotation angle is 45 degree + 90m degree; where m is an integer.

According to another aspect of the present invention, the rotating of the polarization is achieved by applying a bias magnetic field to the first Faraday rotator by means of a permanent magnet.

According to the present invention, the rotating of the polarization is achieved by means of a second Faraday rotator and a permanent magnet, the second Faraday rotator being different from the first Faraday rotator, and the permanent magnet is configured to apply a bias magnetic field to the second Faraday rotator.

According to the present invention, the method further comprises at least partly providing a magnetic shield at an external periphery of the permanent magnet, whereby the magnetic shield reduces an effect of the permanent magnet on the first Faraday rotator.

According to the present invention, without the need of a complex configuration, the optical fiber type magnetic field sensor is capable of determining a direction of a magnetic field. Using an optical fiber allows prevention of signal quality deterioration when a transmission path is long, and allows realization of high environment resistance. Therefore, the present invention allows a more accurate and detailed magnetic field measurement in a severe environment.

BRIEF DESCRIPTION OF THE DRAWINGS

The present invention is further described in the detailed description which follows, in reference to the noted plurality of drawings by way of non-limiting examples of exemplary embodiments of the present invention, in which like reference numerals represent similar parts throughout the several views of the drawings. It should be understood that even though embodiments are separately described, single features thereof may be combined to additional embodiments.

Fig. 1 is an overall pattern diagram of an optical fiber type magnetic field sensor according to a first embodiment of the present invention;
Fig. 2 (A) is an enlarged pattern diagram of a magnetic field probe of the optical fiber type magnetic field sensor according to the first embodiment of the present invention;
Fig. 2 (B) is an enlarged pattern diagram of a variation of the magnetic field probe illustrated in Fig. 2 (A);
Fig. 3 is a pattern diagram explaining a relationship between a polarization axis of a polarizer and a transmitted light amount;
Fig. 4 is pattern diagram expressing a state of a signal after an optical receiver according to the first embodiment of the present invention;
Fig. 5 is a pattern diagram illustrating an optics of an optical fiber type magnetic field sensor according to a second embodiment of the present invention;
Fig. 6 is an enlarged pattern diagram of a magnetic field probe of the optical fiber type magnetic field sensor according to the second embodiment of the present invention;
Fig. 7 is an enlarged pattern diagram of a magnetic field probe of an optical fiber type magnetic field sensor according to a third embodiment of the present invention;
Fig. 8 is a pattern diagram for explaining a reflection type magnetic field probe of a conventional optical fiber type magnetic field sensor; and
Fig. 9 is a pattern diagram for explaining a transmission type magnetic field probe of a conventional optical fiber type magnetic field sensor.

DETAILED DESCRIPTION OF THE INVENTION

The particulars shown herein are by way of example and for purposes of illustrative discussion of the embodiments of the present invention only and are presented in the cause of providing what is believed to be the most useful and readily understood description of the principles and conceptual aspects of the present invention. In this regard, no attempt is made to show structural details of the present invention in more detail than is necessary for the fundamental understanding of the present invention, the description is taken with the drawings making apparent to those skilled in the art how the forms of the present invention may be embodied in practice.

In the following, with reference to the drawings, an example of an embodiment of the present invention is explained in detail.

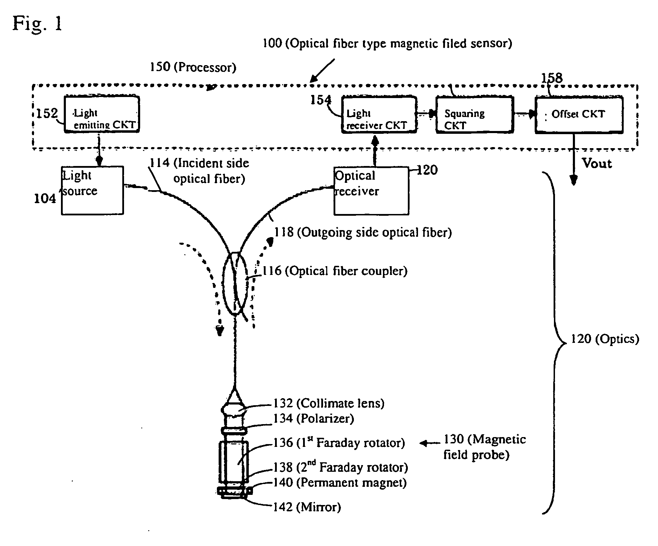

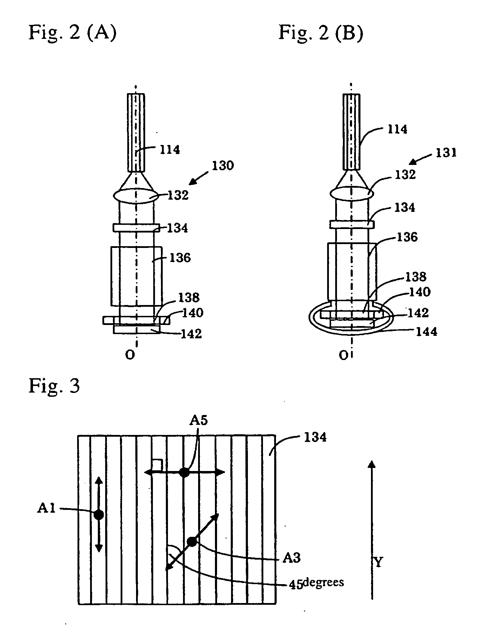

First, an overview of an optical fiber type magnetic field sensor according to a first embodiment is explained using Fig. 1 and Fig. 2 (A).

As illustrated in Fig. 1 and Fig. 2 (A), an optical fiber type magnetic field sensor 100 has: a light source 104; an incident side optical fiber (as a particular optical fiber) 114 guiding light from the light source 104; a polarizer 134 linearly polarizing the light outgoing from the incident side optical fiber 114; a first Faraday rotator 136 rotating polarization of the linearly polarized light by an intensity of an external magnetic field; an optical receiver 120, based on the polarization-rotated light, performing a photoelectric conversion to output the light as an electrical signal; and a processor 150 processing the electrical signal to output the intensity of the external magnetic field as an output voltage value.

As illustrated in Fig. 1 and Fig. 2 (A), the optical fiber type magnetic field sensor 100 includes a second Faraday rotator 138 and a ring-shaped permanent magnet 140 (as a particular polarization rotator), further providing a certain non-90n degree (where n is an integer) polarization rotation angle (for example, 45 degree), to a polarization rotation angle of the light outgoing from the first Faraday rotator 136, with respect to a polarization axis of the polarizer 134; and a mirror 142. The mirror 142 reflects light having been polarization-rotated by the second Faraday rotator 138, and makes the light incident to the polarizer 134. Therefore, the mirror 142 and the polarizer 134 particularly function as an attenuator attenuating an amount of light guided to the optical receiver 120, particularly by providing the certain polarization rotation angle (for example, 45 degree) by the second Faraday rotator 138.

In the following, a configuration of the optical fiber type magnetic field sensor 100 is explained in more detail based on Fig. 1 and Fig. 2 (A).

As illustrated in Fig. 1, the optical fiber type magnetic field sensor 100 has an optics 102 and the processor 150. As illustrated in Fig. 1, the optics 102 includes: the light source 104; the incident side optical fiber 114; an optical fiber coupler 116; an outgoing side optical fiber 118; the optical receiver 120; and/or a reflection type magnetic field probe 130.

As illustrated in Fig. 1, the light source 104 particularly has a laser diode, a LED, and the like. The incident side optical fiber 114 is connected to the light source 104, and at least partly guides light from the light source 104 to the magnetic field probe 130. A part of the light guided to the magnetic field probe 130 is photoelectric-converted by another detector (not shown in the figure) and its output is or may be monitored. Such a configuration is also one of embodiments. According to the monitored output, an electrical signal output from the optical receiver 120 is made a normalized voltage value at a light receiver circuit 154. The optical fiber coupler 116 particularly is formed by fusion joining the incident side optical fiber 114 and the outgoing side optical fiber 118. Light returning from the magnetic field probe 130 to the incident side optical fiber 114 at least partly is branched to the outgoing side optical fiber 118. The outgoing side optical fiber 118 is connected to the optical receiver 120. At the optical receiver 120, a coming light, passing through the outgoing side optical fiber 118, at least partly is photoelectric-converted and output to the processor 150 as an electrical signal. For the incident side optical fiber 114 and the outgoing side optical fiber 118, a single mode fiber, a multimode fiber, a polarization-preserving type optical fiber, and the like, can be used.

As illustrated in Fig. 2 (A), the magnetic field probe 130 includes a lens 132, the polarizer 134, the first Faraday rotator 136, the second Faraday rotator 138, the permanent magnet 140, and/or the mirror 142.

As illustrated in Fig. 2 (A), the lens 132 collimates the light guided by the incident side optical fiber 114, and at least partly makes it incident to the polarizer 134. The polarizer 134 linearly polarizes the light outgoing from the incident side optical fiber 114 and being collimated. The first Faraday rotator 136 rotates polarization of the linearly polarized light (simply called linear polarization) particularly by an intensity of an external magnetic field in a magnetic field detection axis direction O. The second Faraday rotator 138 is arranged at a subsequent stage of the first Faraday rotator 136 separately from the first Faraday rotator 136. At an external periphery of the second Faraday rotator 138, the (particularly substantially ring-shaped) permanent magnet 140 is arranged. This permanent magnet 140 particularly applies or is able to apply a bias magnetic field to the second Faraday rotator 138. Thereby, the second Faraday rotator 138 further provides a polarization rotation angle particularly of about 22.5 degree in addition to a polarization rotation angle of the light outgoing from the first Faraday rotator 136.

As illustrated in Fig. 2 (A), at an end of the magnetic field probe 130, the mirror 142 is arranged. The mirror 142 (particularly substantially vertically) reflects the light that has been polarization-rotated by the second Faraday rotator 138. The light reflected by the mirror 142 is again provided with a polarization rotation angle particularly of about 22.5 degree at the second Faraday rotator 138. That is, with respect to the polarization axis of the polarizer 134, the second Faraday rotator 138 further provides a certain (predetermined or predeterminable) polarization rotation angle particularly of about 45 degree to the polarization rotation angle of the light outgoing from the first Faraday rotator 136. And, the light reflected by the mirror 142 is made incident to the polarizer 134. For both the first Faraday rotator 136 and the second Faraday rotator 138 particularly a material having the Faraday effect (mainly a YIG crystal and the like) can be used. In doing this, a YIG crystal having a large Verdet constant is more desirable.

Here, Fig. 3 is used to explain that, with respect to the polarization axis of the polarizer 134, the second Faraday rotator 138 particularly further provides a certain (predetermined or predeterminable) polarization rotation angle particularly of about 45 degree to the polarization rotation angle of the light outgoing from the first Faraday rotator 136. In this regard, it is assumed for the present explanation that a component of light in the polarization axis direction transmits 100% at the polarizer 134 (a loss other than due to a polarization direction is ignored).

In Fig. 3, when a polarization axis Y of the polarizer 134 and a linear polarization A1 are parallel to each other (with respect to the polarization axis Y, a polarization rotation angle of the linear polarization (called an azimuthal angle) is 0 degree), the linear polarization A1 transmits 100% with respect to the polarizer 134. However, when the polarization axis Y and a linear polarization A3 are perpendicular to each other (azimuthal angle is 90 degree), the linear polarization A3 does not transmit at all (0% transmission) with respect to the polarizer 134. As an intermediate case, when the polarization axis Y and a linear polarization A2 form a 45 degree angle (azimuthal angle is 45 degree), the linear polarization A2 particularly transmits 70.7% (according to cos(45 degree) = 0.707) with respect to the polarizer 134. That is, in the present embodiment, even without an external magnetic field, the second Faraday rotator 138 provides a polarization rotation angle particularly of 45 degree to the linear polarization by the polarizer 134. Therefore, even without an external magnetic field, amount of light returning to the incident side optical fiber 114 via the polarizer 134 particularly is only 70.7% of the amount of light of the linear polarization outgoing from the polarizer 134.

As illustrated in Fig. 2 (B), in order to reduce an effect of the permanent magnet 140 on the first Faraday rotator 136, a magnetic shield 144 may be at least partly provided at an external periphery of the permanent magnet 140. As illustrated in Fig. 2 (B), for example, the magnetic shield 144 can be configured to cover peripheries of the second Faraday rotator 138, the permanent magnet 140 and the mirror 142, and have an opening only at a light passing section. As the magnetic shield 144, for example, a perm alloy and the like can be used. Without providing a magnetic shield, it is also possible to arrange the permanent magnet 140 and the first Faraday rotator 136 sufficiently separated so as to avoid creating a magnetic effect on the first Faraday rotator 136 by the permanent magnet 140.

As illustrated in Fig. 1, the processor 150 includes a light emitting circuit 152, the light receiver circuit 154, a squaring circuit 156 (which is a squarer), and/or an offset circuit 158 (which is an offsetter).

As illustrated in Fig. 1, the light emitting circuit 152 allows the light source 104 to provide a stable emission of light. The light receiver circuit 154 particularly outputs an electrical signal output from the optical receiver 120 as a normalized voltage value to the squaring circuit 156. The squaring circuit 156 squares the voltage value output from the light receiver circuit 154 and outputs a squared voltage value. Here, when the normalized voltage value particularly is 70.7% with respect to a normalization value, the squared voltage value output from the squaring circuit 156 is 0.5 (= 0.707²; a value of 50% with respect to a normalized squared voltage value). The offset circuit 158 uses a squared voltage value of 0.5 as an offset, performs a gain adjustment, inverts a sign of plus or minus when needed, and outputs an output voltage value Vout.

Next, operation of the optical fiber type magnetic field sensor 100 of the present embodiment is explained mainly using Fig. 1.

Light is emitted from the light source 104 by the light emitting circuit 152. The light emitted from the light source 104 is at least partly guided by the incident side optical fiber 114.

The guided light is emitted from the incident side optical fiber 114, and at least partly is collimated by the lens 132. The collimated light is at least partly made incident to the polarizer 134, and is linearly polarized. The linearly polarized light is polarization-rotated at the first Faraday rotator 136 particularly by an intensity of an external magnetic field. The polarization-rotated light is further polarization-rotated particularly for 22.5 degree at the second Faraday rotator 138. Then, the light is (particularly substantially vertically) reflected by the mirror 142, and is again further polarization-rotated particularly for 22.5 degree at the second Faraday rotator 138. That is, the second Faraday rotator 138 provides a certain polarization rotation angle particularly of total 45 degree. The light passing through the second Faraday rotator 138 is further polarization-rotated also at the first Faraday rotator 136 particularly by the intensity of the external magnetic field. The light is at least partly made incident to the polarizer 134, and, according to an azimuthal angle with respect to the polarization axis of the polarizer 134, attenuates to pass through.

The attenuated light again returns to the incident side optical fiber 114 at the lens 132. Via the optical fiber coupler 116, the returning light is at least partly guided by the outgoing side optical fiber 118 to the optical receiver 120.

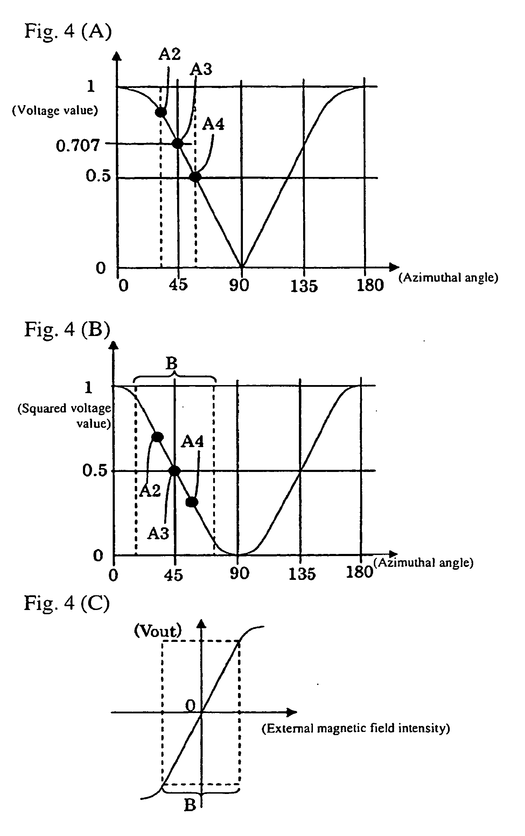

The optical receiver 120 performs a photoelectric conversion in proportion to the amount of the returning light (optical fiber feedback light amount) and outputs an electrical signal. The electrical signal is output by the light receiver circuit 154 as a normalized voltage value. An example of this voltage value is illustrated in Fig. 4 (A). The voltage value, according to an attenuation characteristic of the polarizer 134, particularly is expressed as a value on a curve of a sine wave characteristic (SIN wave). In the case of A3, where an external magnetic field does not exist, the second Faraday rotator 138 (and the permanent magnet 140) provides a 45 degree as a certain polarization rotation angle to light. Therefore, for an azimuthal angle of 45 degree as in a state of A3, for which an external magnetic field does not exist, the voltage value is not a maximum value or a minimum value; the voltage value is 0.707. In the case of A2, where an external magnetic field is minus, the azimuthal angle is less than 45 degree. Therefore, the voltage value is larger than 0.707. In an opposite manner, in the case of A4, where an external magnetic field is plus, the azimuthal angle is larger than 45 degree. Therefore, the voltage value is less than 0.707.

That is, by providing a certain non-90n degree (where n is an integer) polarization rotation angle to the polarization rotation angle of the light outgoing from the first Faraday rotator 136 with respect to the polarization axis of the polarizer 134, a plus or minus sign of an external magnetic field (that is, a direction of the external magnetic field) can be easily determined from an voltage value in proportion to an amount of light received.

The voltage value output from the light receiver circuit 154 particularly is squared by the squaring circuit 156. That is, the squared voltage value output from the squaring circuit 156, as an example, can be illustrated as in Fig. 4 (B). That is, the voltage value of 0.707 of the state of A3, for which an external magnetic field does not exist, becomes a squared voltage value of 0.5. At the same time, the curve expressing a sine wave characteristic can become extremely close to a straight line in a range B centered on a squared voltage value of 0.5. That is, in the range B centered on an azimuthal angle of 45 degree, an azimuthal angle can be obtained in proportion to a squared voltage value. That is, without the need of a complex configuration, the intensity of the external magnetic field, including the direction of the external magnetic field, can be accurately obtained.

The output of the squaring circuit 156 is subjected to a sign adjustment, an offset adjustment and gain adjustment at the offset circuit 158. That is, the output voltage value Vout output from the offset circuit 158, as an example, can be illustrated as in Fig. 4 (C). Therefore, with a simple configuration, the intensity of the external magnetic field, including the direction of the external magnetic field, can be easily and accurately obtained.

In the present embodiment, simplification of the processor 150 allows a price reduction and/or a fast response. Specifically, in a case of the present embodiment where the output voltage value Vout is an analog output, the processor 150 can be made with all analog circuits, and no digital circuits are necessary. Therefore, even when the first Faraday rotator 136 and the second Faraday rotator 138 are used, realization of cost reduction is possible. At the same time, when there are only analog circuits, there is no constraint imposed by a sampling rate used in a digital circuit. Therefore, analog computing allows a fast response. That is, the present embodiment can be used for measurement of a fast varying magnetic field and/or dynamic measurement of a magnetic field distribution by fast moving the magnetic field probe 130.

Further, in the present embodiment, the permanent magnet 140 particularly is used to apply a bias magnetic field to the second Faraday rotator 138. Therefore, there is no need for an external wiring for the magnetic field probe 130 other than the incident side optical fiber 114. Therefore, there is a great flexibility for the arrangement of the magnetic field probe 130, and the second Faraday rotator 138 can be stably controlled without external control.

Further, in the present embodiment, by using the mirror 142 to reflect light, the light travels reciprocally along the respective magnetic field detection axis direction O of the first Faraday rotator 136 and the second Faraday rotator 138. Therefore, the length of the magnetic field detection axis direction O of the first Faraday rotator 136 and the second Faraday rotator 138 particularly can be shortened. Therefore, the magnetic field probe 130 can be made in a small size. Further, the mirror 142 functionally is a terminal member of the magnetic field probe 130. Therefore, no member such as an optical fiber is arranged on the outside of the mirror 142, making installation of the magnetic field probe 130 easy.

That is, in the present embodiment, without taking a complex configuration, the optical fiber type magnetic field sensor allows determination of a direction of a magnetic field. Particularly using an optical fiber allows a reduction in transmission loss without being affected by electrical noise in particular as compared to a case of using an electrical signal. Therefore, it allows prevention of signal quality deterioration when a transmission path is long, and allows realization of high environment resistance. Therefore, in the present embodiment, a more accurate and detailed magnetic field measurement can be achieved in a severe environment.

In the present embodiment, the second Faraday rotator 138 particularly is used, and it is desirable that the permanent magnet 140 does not affect the first Faraday rotator 136. However, the present invention is not limited to this. It is also possible that, without using a second Faraday rotator, a permanent magnet is used to apply a bias magnetic field to a first Faraday rotator to provide a certain polarization rotation angle at the first Faraday rotator, and an external magnetic field is superimposed on the bias magnetic field.

Further, in the present embodiment, the optical fiber coupler 116 particularly is used. However, the present invention is not limited to this. For example, it is also possible to use a beam splitter that is not of an optical fiber type.

Further, in the present embodiment, the processor 150 particularly includes the squaring circuit 156 as a squarer and the offset circuit 158 as an offsetter. However, the present invention is not limited to this. It is also possible to realize a squarer and an offsetter by performing A/D conversion to an output of a receiver circuit and performing a software arithmetic processing, without taking the form of circuits.

Further, in the present embodiment, the second Faraday rotator 138 particularly is arranged at a subsequent stage of the first Faraday rotator 136, and the permanent magnet 140 particularly is arranged at the external periphery of the second Faraday rotator 138. However, the present invention is not limited to this. It is also possible to arrange a second Faraday rotator at a previous stage of a first Faraday rotator. And, it is also possible to arrange a permanent magnet apart from a second Faraday rotator with respect to a magnetic field detection axis direction O. It is also possible that the shape of the permanent magnet is not a ring shape.

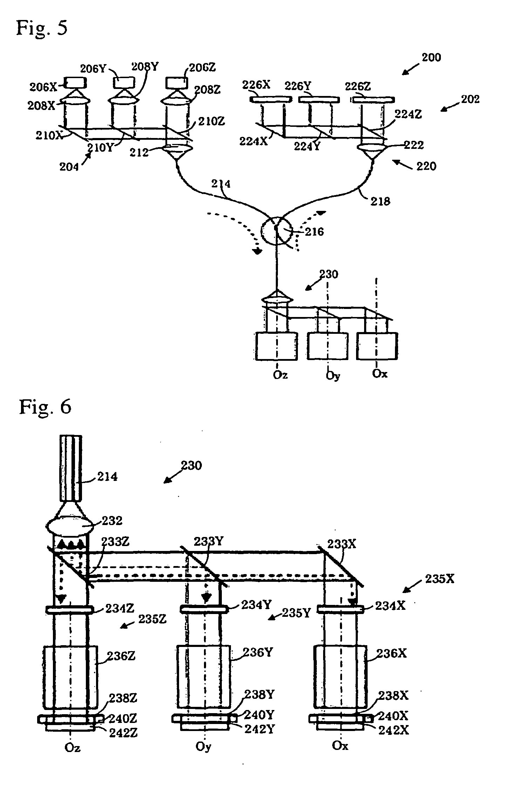

Next, a second embodiment of the present invention is explained using Fig. 5 and Fig. 6.

In the present embodiment, the reflection type magnetic field probe 130 of the first embodiment is made multiaxial. A schematic configuration of this is as illustrated in Fig. 5 and Fig. 6. Light of a plurality of wavelengths $\lambda 1$ - $\lambda 3$ from a light source 204 is guided to an incident side optical fiber 214. Light outgoing from the incident side optical fiber 214 is dispersed into each of the wavelengths $\lambda 1$ - $\lambda 3$, and for each of the wavelengths $\lambda 1$ - $\lambda 3$, first Faraday rotators 236X - 236Z are respectively used. In this case, the light outgoing from the incident side optical fiber 214 is dispersed into each of the wavelengths by two dichroic mirrors 233Y and 233Z. Specific configuration is explained in the following. Other than related to a part involving multiaxial, explanation is omitted as appropriate.

As illustrated in Fig. 5, the light source 204, for example, includes three LEDs 206X - 206Z, four lenses 208X - 208Z and 212, one mirror 210X and two dichroic mirrors 210Y and 210Z. The three LEDs 206X - 206Z respectively emit light of different wavelengths $\lambda 1$ - $\lambda 3$. The light emitted from the LEDs 206X - 206Z is respectively collimated by the lenses 208X - 208Z. The collimated light is reflected by the mirror 210X and the dichroic mirrors 210Y and 210Z, and is made incident to the lens 212. Via the lens 212, the light having respectively different wavelengths $\lambda 1$ - $\lambda 3$ is guided by the one incident side optical fiber 214 to a magnetic field probe 230.

As illustrated in Fig. 6, the magnetic field probe 230 includes three probe distal portions 235X - 235Y, having only a lens 232 in common. The probe distal portions 235X - 235Z include, respectively, a mirror 233X or dichroic mirrors 233Y and 233Z, polarizers 234X - 234Z, first Faraday rotators 236X - 236Z, second Faraday rotators 238X - 238Z, permanent magnets 240X - 240Z, and mirrors 242X - 242Z.

As illustrated in Fig. 6, light outgoing from the incident side optical fiber 214 is collimated by the lens 232. The collimated light is made incident the dichroic mirror 233Z. Here, the dichroic mirror 233Z reflects light of wavelengths $\lambda 1$ and $\lambda 2$, and transmits light of wavelength $\lambda 3$. The light reflected by the dichroic mirror 233Z is made incident to the dichroic mirror 233Y. The dichroic mirror 233Y transmits light of wavelength $\lambda 1$ and reflects light of wavelength $\lambda 2$. The light transmitted through the dichroic mirror 233Y is reflected by the mirror 233X. The light dispersed by the mirror 233X and the dichroic mirrors 233Y and 233Z is respectively made incident to the mirrors 242X - 242Z via the polarizers 234X - 234Z, the first Faraday rotators 236X - 236Z and the second Faraday rotators 238X - 238Z. The light reflected by the mirrors 242X - 242Z is respectively guided to the incident side optical fiber 214 via the mirror 233X and the dichroic mirrors 233Y and 233Z. Other configuration and operation of the magnetic field probe 230 are the same as in the first embodiment, and therefore, the description thereof is not repeated.

As illustrated in Fig. 5, an optical receiver 220 includes a lens 222, a mirror 224X and dichroic mirrors 224Y and 224Z, and photoelectric sensors 226X - 226Z. Light outgoing from an outgoing side optical fiber 218 is collimated by the lens 222, and is dispersed into each of the wavelengths $\lambda 1$ - $\lambda 3$ by the dichroic mirrors 224Y and 224Z, and the dispersed light is received by the photoelectric sensors 226X - 226Z. The light received by the photoelectric sensors 226X - 226Z is photoelectric-converted, and is output as electrical signals to a processor. The processor has the substantially same or similar configuration as in the first embodiment, and performs the same operation. Therefore, the description thereof is not repeated. It is also possible to have the same number of processors as the wavelengths and arrange the processors in parallel. It is also possible to share a processor as appropriate for different wavelengths.

As described above, the probe distal portions 235X - 235Z are respectively provided for each of the wavelengths $\lambda 1$ - $\lambda 3$, and can be arranged, for example, in such a way that magnetic field detection axis directions Ox - Oz of the probe distal portions 235X - 235Z are mutually perpendicular. By doing this, it is possible to measure an intensity of a 3-dimensional magnetic field. That is, by vector-synthesizing output voltage values Vout obtained with respect to the axes, a direction and a magnitude of a magnetic field can be obtained.

In making it multiaxial, the reflection type magnetic field probe 230 is used. Therefore, installation of the probe distal portions 235X - 235Z is easy. At the same time, by using the two dichroic mirrors 233Y and 233Z, the magnetic field probe 230 can be compactly assembled in a synergistic manner. And, by also using the two dichroic mirrors 224Y and 224Z in the optical receiver 220, the optical receiver 220 also can be compactly assembled.

In the present embodiment, intensities of a magnetic field along 3 axis directions are obtained using 3 wavelengths $\lambda 1$ - $\lambda 3$. However, the present invention is not limited to this, but is also applicable to a case of a greater number of axes. As far as an optical fiber particularly is used, wavelength multiplexing is easy. And, only one optical fiber is required. Further, it is not necessary to involve in any way any electrical signal in a magnetic field probe. Therefore, even for a case of a large number of axes, a magnetic field probe can be easily configured. Even when the magnetic field probe 230 is arranged far away from the light source 204 and the optical receiver 220, an intensity of a magnetic field with respect to each of the axes can be stably obtained.

In the present embodiment, the light outgoing from the incident side optical fiber 214 particularly is dispersed into each of the wavelengths λ1 - λ3 by the two dichroic mirrors 233Y and 233Z. However, the present invention is not limited to this. It is also possible to use an optical element having a different wavelength selectivity in place of a dichroic mirror.

Next, a third embodiment of the present invention is explained using Fig. 7.

The present embodiment, different from the first embodiment, uses a transmission type magnetic field probe 330. That is, in place of the second Faraday rotator 138, the permanent magnet 140, the mirror 142 and the polarizer 134 (when a reflected light returns), an analyzer 344 is used. The analyzer 344 is arranged to have a polarization axis angle different from that of a polarizer 334 (for example, 45 degree). And, light passing through the analyzer 344 is collected by a lens 346, and is made directly incident to an outgoing side optical fiber 318. That is, the analyzer 344, particularly with a polarization axis 45 degree different from the polarization axis of the polarizer 334 (providing a polarization rotation angle of 45 degree), in place of the polarizer 334, passes light outgoing from a first Faraday rotator 336. For this reason, as compared to the first embodiment, the analyzer 344 further provides a certain non-90n degree (where n is an integer) polarization rotation angle (for example, 45 degree), to the polarization rotation angle of the light outgoing from the first Faraday rotator 336, with respect to the polarization axis of the polarizer 334. At the same time, the analyzer 344, by providing a certain polarization rotation angle (for example, 45 degree), attenuates amount of light guided to an optical receiver. That is, in the present embodiment, the analyzer 344, particularly being arranged to have a polarization axis angle 45 degree different from that of the polarizer 334, functions in the same way as the polarization rotator in the first embodiment. At the same time, the analyzer 344, as a polarization rotator, also functions as an attenuator (functions as both a polarization rotator and an attenuator).

For this reason, the same operation as the optical fiber type magnetic field sensor 100 described in the first embodiment is possible. Further, in the present embodiment, only one Faraday rotator 336 is used. Therefore, as compared to the first embodiment, it is possible to lower costs. Further, a permanent magnet is not used. Therefore, the magnetic field probe 330 can be configured and arranged without the need of considering an effect due to a permanent magnet on the first Faraday rotator 336.

Further, it is also possible to particularly use the transmission type magnetic field probe 330 of the present embodiment to make it multiaxial as described in the second embodiment.

The present invention is explained using the above described embodiment. However, the present invention is not limited to the above described embodiments. That is, improvements and design changes are possible without departing from the scope of the present invention.

In the above described embodiments, the certain polarization rotation angle particularly was about 45 degree. However, the present invention is not limited to this. When the certain polarization rotation angle is 45 degree, regardless of a direction of a magnetic field, an intensity of the magnetic field can be accurately obtained within an equal broad range when making a straight-line approximation (for example, in Fig. 4 (B), azimuthal angles are each within a range of B/2). For this reason, it is desirable that the certain polarization rotation angle is 45 degrees + 90m degrees (where m is an integer). However, it may be also any non-90n degree angle (where n is an integer). In that case, an amount of light received, in a state where an external magnetic field does not exist, is not a maximum value or a minimum value on a curve expressing a sine wave characteristic. For this reason, when the direction of the magnetic field changes, the amount of light received (the voltage value, the squared voltage value or the output voltage value) changes. Therefore, the direction of the magnetic field can be determined.

Further, in the above described embodiments, as a polarizer or an analyzer, a polarization plate particularly was assumed. However, the present invention is not limited to this. For example, a polarization beam splitter or a birefringent crystal (a calcite or the like) may also be used.

Further, in the above described embodiments, as light source, a laser diode or LED was used. However, something else may also be used. However, it is desirable that it emits a light wavelength transparent with respect to the material of a Faraday rotator. For example, it is desirable that it is a light source of a wavelength of about 1 μm with respect to a YIG crystal.

Further, in the above described embodiments, the processor particularly included a squarer squaring an electrical signal. However, the present invention is not limited to this. It is also possible not to have a squarer.

It is noted that the foregoing examples have been provided merely for the purpose of explanation and are in no way to be construed as limiting of the present invention. While the present invention has been described with reference to exemplary embodiments, it is understood that the words which have been used herein are words of description and illustration, rather than words of limitation. Changes may be made, within the purview of the appended claims . Although the present invention has been described herein with reference to particular structures, materials and embodiments, the present invention is not intended to be limited to the particulars disclosed herein; rather, the present invention extends to all structures and methods such as are within the scope of the appended claims.

The present invention is not limited to the above described embodiments, and various variations and modifications may be possible without departing from the scope of the present invention.

**Claims**

1. A magnetic field sensor (100) comprising:

   a light source (104, 204);
   an optical fiber (114; 214) configured to guide light emitted from the light source (104, 204);
   a polarizer (134; 334) configured to linearly polarize light emitted from the optical fiber (114; 214);
   a first Faraday rotator (136; 236; 336) configured to rotate polarization of the linearly polarized light by an intensity of an external magnetic field;
   an optical receiver (120; 220) configured to performing a photoelectric conversion to output the light as an electrical signal, based on the polarization-rotated light;
   a processor (150) configured to process the electrical signal to output the intensity of the external magnetic field as an output voltage value;
   a polarization rotator (140; 138) configured to provide a predetermined non-90n degree polarization rotation angle, where n is an integer, to a polarization rotation angle of light outgoing from the first Faraday rotator (136; 236; 336), with respect to a polarization axis of the polarizer (134; 334); and
   an attenuator (142, 134; 344) configured to attenuate an amount of light guided to the optical receiver (120; 220) by providing the predetermined polarization rotation angle,
   **characterized in that**
   the polarization rotator (140; 138) comprises a second Faraday rotator (138) and a permanent magnet (140), the second Faraday rotator (138) being different from the first Faraday rotator (136; 236; 336), and the permanent magnet (140) is configured to apply a bias magnetic field to the second Faraday rotator (138), wherein a magnetic shield (144) is at least partly provided at an external periphery of the permanent magnet (140), the magnetic shield (144) configured to reduce an effect of the permanent magnet (140) on the first Faraday rotator (136; 236; 336).

2. The magnetic field sensor according to claim 1, wherein the predetermined polarization rotation angle is 45 degree + 90m degree, where m is an integer.

3. The magnetic field sensor according to any one of the preceding claims, wherein the polarization rotator (140; 138) comprises a permanent magnet (140) configured to apply a bias magnetic field to the first Faraday rotator (136; 236; 336).

4. The magnetic field sensor according to any one of the preceding claims, wherein the attenuator (142, 134; 344) has a mirror (142) configured to reflect light polarization-rotated by one of the first Faraday rotator (136; 236; 336) and particularly the second Faraday rotator (138), and the light reflected by the mirror (142) is made incident to the polarizer (134; 334).

5. The magnetic field sensor according to any one of the preceding claims, wherein the attenuator (142, 134; 344) has an analyzer having a polarization axis angle different from that of the polarizer (134; 334).

6. The magnetic field sensor according to any one of the preceding claims, wherein light of a plurality of wavelengths from the light source (104, 204) is guided to the optical fiber (114; 214), light outgoing from the optical fiber (114; 214) is dispersed into each of the wavelengths, and the first Faraday rotator (136; 236; 336) is respectively used with respect to each of the wavelengths.

7. The magnetic field sensor according to claim 6, wherein the light outgoing from the optical fiber (114; 214) is dispersed into each of the wavelengths by using at least one dichroic mirror (233Y; 233Z).

8. The magnetic field sensor according to any one of the preceding claims, wherein the processor (150) has a squarer (156) configured to square the electrical signal.

9. A method of sensing a magnetic field, comprising the following steps:

   generating linearly polarized light;
   guiding the light to a first Faraday rotator (136; 236; 336) configured to rotate polarization of the linearly polarized light by an intensity of an external magnetic field;
   performing a photoelectric conversion by means of an optical receiver (120; 220) to output the light as an electrical signal, based on the polarization-rotated light;
   processing the electrical signal to output the intensity of the external magnetic field as an output voltage value;
   providing a predetermined non-90n degree polarization rotation angle, where n is an integer, to a polarization rotation angle of light outgoing from the first Faraday rotator (136; 236; 336), with respect to a polarization axis of the polarized light; and
   attenuating an amount of light guided to the optical receiver (120; 220) by providing the predetermined polarization rotation angle,
   **characterized in that**

the rotating of the polarization is achieved by means of a second Faraday rotator (138) and a permanent magnet (140), the second Faraday rotator (138) being different from the first Faraday rotator (136; 236; 336), and the permanent magnet (140) is configured to apply a bias magnetic field to the second Faraday rotator (138), and

at least partly providing a magnetic shield (144) at an external periphery of the permanent magnet (140), whereby the magnetic shield (144) reduces an effect of the permanent magnet (140) on the first Faraday rotator (136; 236; 336).

10. The method according to claim 9, wherein the predetermined polarization rotation angle is 45 degree + 90m degree, where m is an integer.

11. The method according to claim 9 or 10, wherein the rotating of the polarization is achieved by applying a bias magnetic field to the first Faraday rotator (136; 236; 336) by means of a permanent magnet (140).

**Patentansprüche**

1. Ein Magnetfeldsensor (100) der Folgendes umfasst:

eine Lichtquelle (104, 204);
eine Glasfaser bzw. einen Lichtwellenleiter (114; 214), die dazu konfiguriert ist, von der Lichtquelle (104, 204) abgegebenes Licht zu leiten;
einen Polarisator (134; 334), der dazu konfiguriert ist, vom Lichtwellenleiter (114; 214) abgegebenes Licht linear zu polarisieren;
einen ersten Faraday-Rotator (136; 236; 336), der dazu konfiguriert ist, die Polarisation des linear polarisierten Lichts durch die Stärke eines externen Magnetfelds zu drehen;
ein optischer Empfänger (120; 220), der dazu konfiguriert ist, eine fotoelektrische Umwandlung auszuführen, um das Licht, ausgehend vom Licht mit gedrehter Polarisation, als elektrisches Signal auszugeben;
ein Prozessor (150), der dazu konfiguriert ist, das elektrische Signal zu verarbeiten, um die Stärke des externen Magnetfelds als Ausgangs-Spannungswert auszugeben;
ein Polarisationsdreher (140; 138), der dazu konfiguriert ist, für den Rotationswinkel der Polarisation des Lichtes, das aus dem ersten Faraday-Rotator (136; 236; 336) ausgeht, bezüglich einer Polarisationsachse des Polarisators (134; 334) einen vorgegebenen Rotationswinkel der Polarisation bereitzustellen, der nicht 90n Grad entspricht, wobei n eine ganze Zahl ist; und

ein Dämpfungsglied (142, 134; 344), das dazu konfiguriert ist, eine zum optischen Empfänger (120; 220) geleitete Lichtmenge zu dämpfen, indem es den vorbestimmten Rotationswinkel der Polarisation bereitstellt,
**dadurch gekennzeichnet, dass**
der Polarisationsdreher (140; 138) einen zweiten Faraday-Rotator (138) und einen Permanentmagneten (140) umfasst, wobei der zweite Faraday-Rotator (138) vom ersten Faraday-Rotator (136; 236; 336) verschieden ist, und dass der Permanentmagnet (140) dazu konfiguriert ist, am zweiten Faraday-Rotator (138) ein statisches (bias) Magnetfeld anzulegen, wobei eine magnetische Abschirmung (144) zumindest teilweise an einer äußeren Peripherie des Permanentmagneten (140) bereitgestellt wird, wobei die magnetische Abschirmung (144) dazu konfiguriert ist, eine Wirkung des Permanentmagneten (140) auf den ersten Faraday-Rotator (136; 236; 336) zu verringern.

2. Der Magnetfeldsensor nach Anspruch 1, wobei der vorbestimmte Rotationswinkel der Polarisation 45 Grad + 90m Grad ist, wobei m eine ganze Zahl ist.

3. Der Magnetfeldsensor nach einem der vorhergehenden Ansprüche, wobei der Polarisationsdreher (140; 138) einen Permanentmagneten (140) umfasst, der dazu konfiguriert ist, am ersten Faraday-Rotator (136; 236; 336) ein statisches Magnetfeld anzulegen.

4. Der Magnetfeldsensor nach einem der vorhergehenden Ansprüche, wobei das Dämpfungsglied (142, 134; 344) einen Spiegel (142) aufweist, der dazu konfiguriert ist, Licht zu reflektieren, deren Polarisation durch den ersten Faraday-Rotator (136; 236; 336) oder insbesondere dem zweiten Faraday-Rotator (138) gedreht wurde, und wobei das vom Spiegel (142) reflektierte Licht auf den Polarisator (134; 334) einfallend gemacht wird.

5. Der Magnetfeldsensor nach einem der vorhergehenden Ansprüche, wobei das Dämpfungsglied (142, 134; 344) einen Analysator aufweist, dessen Winkel der Polarisationsachse sich von demjenigen des Polarisators (134; 334) unterscheidet:

6. Der Magnetfeldsensor nach einem der vorhergehenden Ansprüche, wobei Licht mit einer Vielzahl an Wellenlängen aus der Lichtquelle (104, 204) zur Glasfaser (114; 214) geleitet wird, wobei Licht, das von der Glasfaser (114; 214) abgeht, in die einzelnen Wellenlängen zerlegt wird, und der erste Faraday-Rotator (136; 236; 336) jeweils in Bezug auf jede einzelne Wellenlänge verwendet wird.

**7.** Der Magnetfeldsensor nach Anspruch 6, wobei das Licht, das von der Glasfaser (114; 214) abgeht, durch die Verwendung von mindestens einem dichroitischen Spiegel (233Y; 233Z) in die einzelnen Wellenlängen zerlegt wird.

**8.** Der Magnetfeldsensor nach einem der vorhergehenden Ansprüche, wobei der Prozessor (150) einen Quadrierer (*squarer*) (156) aufweist, der dazu konfiguriert ist, das elektrische Signal zu quadrieren.

**9.** Ein Verfahren zur Messung (*sensing*) eines Magnetfelds, das folgende Schritte umfasst:

generieren von linear polarisiertem Licht; leiten des Lichts zu einem ersten Faraday-Rotator (136; 236; 336), der dazu konfiguriert ist, die Polarisation des linear polarisierten Lichts durch eine Stärke eines externen Magnetfelds zu drehen; ausführen einer fotoelektrische Umwandlung mittels eines optischen Empfängers (120; 220), um das Licht als elektrisches Signal auszugeben, ausgehend vom Licht mit gedrehter Polarisation; verarbeiten des elektrischen Signals, um die Stärke des externen Magnetfelds als Ausgangs-Spannungswert auszugeben; bereitstellen eines vorbestimmten Rotationswinkels der Polarisation, der nicht 90n Grad entspricht, wobei n eine ganze Zahl ist, für einen Rotationswinkel der Polarisation des Lichts, das aus dem ersten Faraday-Rotator (136; 236; 336) ausgeht, in Bezug auf eine Polarisationsachse des polarisierten Lichts; und dämpfen einer Lichtmenge, die zum optischen Empfänger (120; 220) geleitet wird durch Bereitstellung des vorbestimmten Rotationswinkels der Polarisation, **dadurch gekennzeichnet, dass** das Drehen der Polarisation mittels eines zweiten Faraday-Rotators (138) und eines Permanentmagneten (140) bewerkstelligt wird, wobei der zweite Faraday-Rotator (138) vom ersten Faraday-Rotator (136; 236; 336) verschieden ist, und wobei der Permanentmagnet (140) dazu konfiguriert ist, am zweiten Faraday-Rotator (138) ein statisches (*bias*) Magnetfeld anzulegen, und wobei eine magnetische Abschirmung (144) zumindest teilweise an einer äußeren Peripherie des Permanentmagneten (140) bereitgestellt wird, wobei die magnetische Abschirmung (144) die Wirkung des Permanentmagneten (140) auf den ersten Faraday-Rotator (136; 236; 336) verringert.

**10.** Das Verfahren nach Anspruch 9, wobei der vorbestimmte Rotationswinkel der Polarisation 45 Grad + 90m Grad ist, wobei m eine ganze Zahl ist.

**11.** Das Verfahren nach Anspruch 9 oder 10, wobei das Drehen der Polarisation durch Anlegen eines statisches Magnetfeld am ersten Faraday-Rotator (136; 236; 336) mittels eines Permanentmagneten (140) bewerkstelligt wird.

## Revendications

**1.** Capteur de champ magnétique (100) comprenant :

une source de lumière (104, 204) ; une fibre optique (114 ; 214) configurée pour guider de la lumière émise par la source de lumière (104 , 204) ; un polariseur (134 ; 334) configuré pour polariser linéairement de la lumière émise par la fibre optique (114 ; 214) ; un premier rotateur de Faraday (136 ; 236 ; 336) configuré pour faire tourner la polarisation de la lumière linéairement polarisée par rapport à une intensité d'un champ magnétique extérieur ; un récepteur optique (120 ; 220) configuré pour effectuer une conversion photoélectrique pour sortir la lumière en tant que signal électrique, en fonction de la lumière à polarisation tournée ; un processeur (150) configuré pour traiter le signal électrique afin de sortir l'intensité du champ magnétique extérieur en tant que valeur de tension de sortie ; un rotateur de polarisation (140 ; 138) configuré pour fournir un angle de rotation de polarisation prédéterminé autre que 90n degrés, sachant que n est un nombre entier, à un angle de rotation de polarisation de lumière sortant du premier rotateur de Faraday (136 ; 236 ; 336), par rapport à un axe de polarisation du polariseur (134 ; 334) ; et un atténuateur (142, 134 ; 344) configuré pour atténuer une quantité de lumière guidée jusqu'au récepteur optique (120 ; 220) en fournissant l'angle de rotation de polarisation prédéterminé, **caractérisé en ce que** le rotateur de polarisation (140 ; 138) comprend un deuxième rotateur de Faraday (138) et un aimant permanent (140), le deuxième rotateur de Faraday (138) étant différent du premier rotateur de Faraday (136 ; 236 ; 336), et **en ce que** l'aimant permanent (140) est configuré pour appliquer un champ magnétique de polarisation (*bias magnetic field*) au deuxième rotateur de Faraday (138), sachant qu'un blindage magnétique (144) est au moins en partie fourni auprès d'une périphérie extérieure de l'aimant permanent (140), le blindage magnétique (144) étant configuré pour réduire un effet de l'aimant permanent (140) sur le premier rotateur de Faraday (136 ; 236 ; 336).

2. Le capteur de champ magnétique d'après la revendication 1, sachant que l'angle de rotation de polarisation prédéterminé comporte 45 degré + 90m degré, sachant que m est un nombre entier.

3. Le capteur de champ magnétique d'après une des revendications précédentes, sachant que le rotateur de polarisation (140 ; 138) comprend un aimant permanent (140) configuré pour appliquer un champ magnétique de polarisation au premier rotateur de Faraday (136 ; 236 ; 336).

4. Le capteur de champ magnétique d'après une des revendications précédentes, sachant que l'atténuateur (142, 134 ; 344) présente un miroir (142) configuré pour réfléchir de la lumière à polarisation tournée par l'un parmi le premier rotateur de Faraday (136 ; 236 ; 336) et notamment le deuxième rotateur de Faraday (138), et que la lumière réfléchie par le miroir (142) est rendue incidente sur le polariseur (134 ; 334).

5. Le capteur de champ magnétique d'après une des revendications précédentes, sachant que l'atténuateur (142, 134 ; 344) présente un analyseur dont un angle de l'axe de polarisation diffère de celui du polariseur (134 ; 334).

6. Le capteur de champ magnétique d'après une des revendications précédentes, sachant que de la lumière incluant une pluralité de longueurs d'onde de la source de lumière (104 ; 204) est guidée jusqu'à la fibre optique (114 ; 214), et que de la lumière sortant de la fibre optique (114 ; 214) est séparée selon chaque longueur d'onde respective, et que le premier rotateur de Faraday (136 ; 236 ; 336) est respectivement utilisé pour chacune des longueurs d'onde.

7. Le capteur de champ magnétique d'après la revendication 6, sachant que la lumière sortant de la fibre optique (114 ; 214) est séparée selon chaque longueur d'onde en utilisant au moins un miroirs dichroïque (233Y ; 233Z).

8. Le capteur de champ magnétique d'après une des revendications précédentes, sachant que le processeur (150) présente un dispositif d'élévation au carré (156) configuré pour élever au carré le signal électrique.

9. Un procédé d'exploration ou encore de mesure (*sensing*) de champ magnétique, comprenant les étapes suivantes :

générer de la lumière linéairement polarisée ;
guider la lumière jusqu'à un premier rotateur de Faraday (136 ; 236 ; 336) configuré pour faire tourner la polarisation de la lumière linéairement polarisée par rapport à une intensité d'un champ magnétique extérieur ;
effectuer une conversion photoélectrique au moyen d'un récepteur optique (120 ; 220) pour sortir la lumière en tant que signal électrique, en fonction de la lumière à polarisation tournée ;
traiter le signal électrique afin de sortir l'intensité du champ magnétique extérieur en tant que valeur de tension de sortie ;
fournir un angle de rotation de polarisation prédéterminé autre que 90n degrés, sachant que n est un nombre entier, à un angle de rotation de polarisation de lumière sortant du premier rotateur de Faraday (136 ; 236 ; 336), par rapport à un axe de polarisation de la lumière polarisée ; et
atténuer une quantité de lumière guidée jusqu'au récepteur optique (120 ; 220) en fournissant l'angle de rotation de polarisation prédéterminé,
**caractérisé en ce que**
le fait de tourner la polarisation est réalisé au moyen d'un deuxième rotateur de Faraday (138) et un aimant permanent (140), le deuxième rotateur de Faraday (138) étant différent du premier rotateur de Faraday (136 ; 236 ; 336), et **en ce que** l'aimant permanent (140) est configuré pour appliquer un champ magnétique de polarisation (*bias magnetic field*) au deuxième rotateur de Faraday (138), et
fournir au moins en partie un blindage magnétique (144) auprès d'une périphérie extérieure de l'aimant permanent (140), le blindage magnétique (144) réduisant un effet de l'aimant permanent (140) sur le premier rotateur de Faraday (136 ; 236 ; 336).

10. Le procédé d'après la revendication 9, sachant que l'angle de rotation de polarisation prédéterminé comporte 45 degré + 90m degré, sachant que m est un nombre entier.

11. Le procédé d'après la revendication 9 ou 10, sachant que le fait de tourner la polarisation est réalisé en appliquant un champ magnétique de polarisation au premier rotateur de Faraday (136 ; 236 ; 336) au moyen d'un aimant permanent (140).

Fig. 1

100 (Optical fiber type magnetic filed sensor)

150 (Processor)

158

152 | Light emitting CKT

154 | Light receiver CKT → Squaring CKT → Offset CKT

Vout

104 Light source

114 (Incident side optical fiber)

120 Optical receiver

118 (Outgoing side optical fiber)

116 (Optical fiber coupler)

120 (Optics)

132 (Collimate lens)
134 (Polarizer)
136 (1st Faraday rotator) ← 130 (Magnetic field probe)
138 (2nd Faraday rotator)
140 (Permanent magnet)
142 (Mirror)

Fig. 2 (A)                    Fig. 2 (B)

Fig. 3

Fig. 4 (A)

Fig. 4 (B)

Fig. 4 (C)

Fig. 5

Fig. 6

EP 2 363 721 B1

Fig. 7

330

314

O

332 334 336 344 346

318

Fig. 8 (A)

Fig. 8 (B)

14 1

30

32

34

36

42

O

1
(Amount of
light received)

0.5

0

C1 C2 C3

-90 -45 0 45 90

(Azimuthal angle)

18

Fig. 9 (A)

Fig. 9 (B)

**REFERENCES CITED IN THE DESCRIPTION**

**Patent documents cited in the description**

- JP HEI322595 B
- US 20020000804 A1
- US 20030133657 A1